# EUROPÄISCHE PATENTSCHRIFT

(11) **EP 2 640 171 B1**
(45) Veröffentlichungstag und Bekanntmachung des Hinweises auf die Patenterteilung: **21.12.2016**
(21) Anmeldenummer: 13153263.2
(22) Anmeldetag: 30.01.2013
(51) Int. Cl.: H05K 1/18, F21K 99/00, H05K 1/14

(54) **Leiterplatte mit regelmäßiger LED-Anordnung**
Circuit board with a regular LED assembly
Plaquette avec agencement LED régulier

(30) Priorität: 30.01.2012 DE 102012100741
(43) Veröffentlichungstag der Anmeldung: 18.09.2013
(73) Patentinhaber: Siteco Beleuchtungstechnik GmbH, 83301 Traunreut (DE)
(72) Erfinder: Lewers, Christoph, 59821 Arnsberg (DE); Woski, Michael, 83301 Traunreut (DE); Hammer, Andreas, 93049 Regensburg (DE)
(74) Vertreter: Schmidt, Steffen

(56) Entgegenhaltungen:
- EP-A1- 1 930 947
- WO-A1-2007/008048
- WO-A1-2007/136020
- WO-A1-2011/004625
- DE-A1-102010 008 876
- DE-U1-202010 004 870
- US-A1- 2002 036 908
- US-A1- 2005 169 007
- US-A1- 2006 279 671
- US-A1- 2008 231 776

## Beschreibung

Die vorliegende Erfindung betrifft Leiterplatten für die Ausbildung von flächigen LED-Leuchten und die Anordnung von mehreren identischen Leiterplatten innerhalb einer LED-Leuchte.

Zur Ausbildung von Leuchten mit einer flächigen Anordnung von LEDs, insbesondere einer regelmäßigen Anordnung von LEDs, z.B. einem quadratischen Gitter, werden Leiterplatten mit in einem Muster vorgegebenen LED-Positionen verwendet. Da jedoch die Leuchten häufig zu groß sind, um alle LEDs auf einer einzigen Leiterplatte anzuordnen, werden mehrere Leiterplatten verwendet, die in der Gesamtleuchte aneinandergefügt werden. Ferner ist zur einfacheren Herstellung häufig gewünscht, dass nur identische Leiterplatten aneinandergefügt werden, um die Anordnung für eine Leuchte zu bilden.

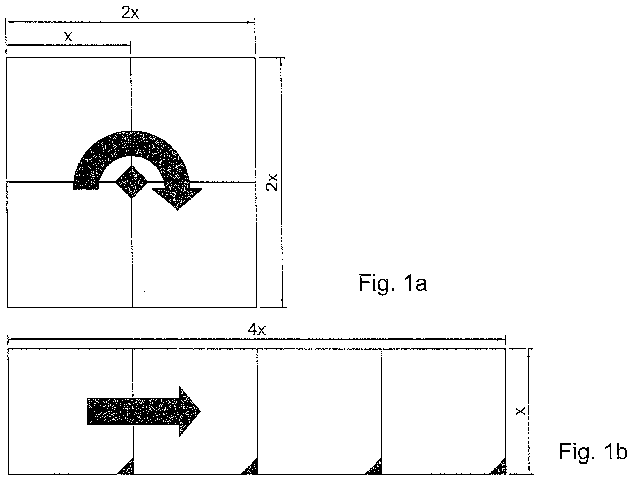

Ein Beispiel einer solchen Anordnung von LED-Leiterplatten ist in den Figuren 1a und 1b dargestellt. Die Leiterplatten sind quadratisch mit einer Seitenlänge x ausgebildet. Sofern die Leiterplatten zur Ausbildung einer Langfeldleuchte (siehe Figur 1b) aneinandergefügt werden, werden sie translationsversetzt mit gleicher Ausrichtung nebeneinander angefügt. Zur Ausbildung einer quadratischen Leuchte (siehe Figur 1a) müssen die Leiterplatten jedoch zur leichteren Kontaktierung zyklisch gedreht aneinandergefügt werden.

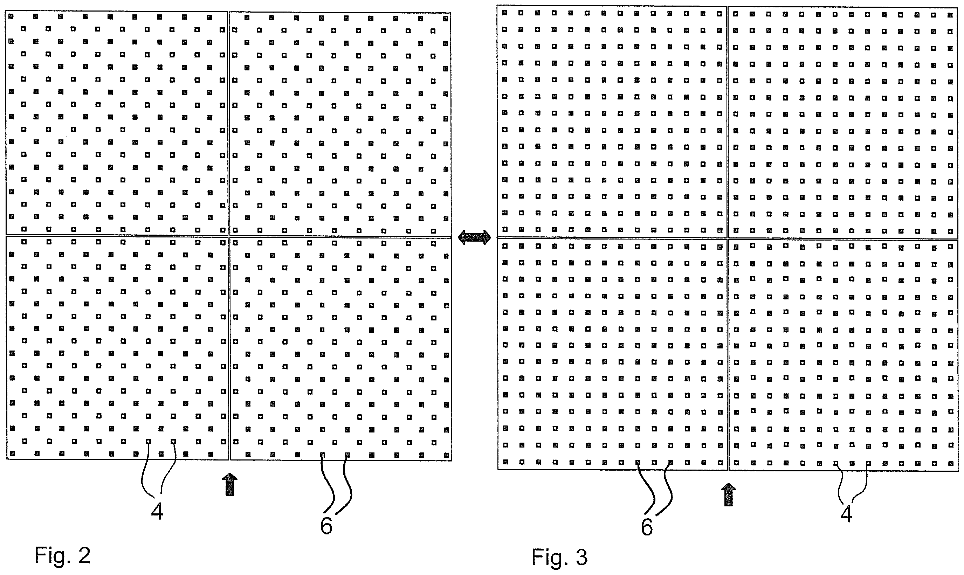

Ferner ist es häufig gewünscht, dass auf den Leiterplatten eine Anordnung von wenigstens zwei unterschiedlichen Gruppen von LEDs vorhanden ist, die unterschiedlich angesteuert werden können oder mit unterschiedlichen LEDs bestückt sind. In den Figuren 2 und 3 sind die LED-Positionen, welche unterschiedlich angesteuert oder bestückt sind, mit transparenten bzw. ausgefüllten Quadraten 4 bzw. 6 dargestellt.

Der Nachteil derartiger quadratischer Leiterplatten in einer Anordnung für eine quadratische Leuchte mit vier solcher Leiterplatten entsprechend der Figur 1a ist in den Figuren 2 und 3 gezeigt. An den aneinandergrenzenden Seiten der Leiterplatten ergibt sich eine Abweichung von dem sonst regelmäßigen Muster in der Fläche. Insbesondere grenzen in diesem Beispiel jeweils zwei Reihen aneinander an, welche - im Unterschied zu der Anordnung innerhalb einer Leiterplatte - identische LED-Positionen nebeneinander aufweisen. Diese Störlinien sind bei der angeschalteten Leuchte selbst dann, wenn eine Abdeckung der LEDs vorgesehen ist, sichtbar.

US 2005/0169007 A1 offenbart eine Rückseitenbeleuchtung für eine LCD-Anzeige, die eine Anordnung von LEDs in verschiedenen Farben in einer Ebene aufweist, wobei die LEDs in einem hexagonalen Gitter angeordnet sind, so dass in einem Dreieck jeweils LEDs in den Farben Rot, Grün und Blau enthalten sind.

WO 2007/136020 A1 offenbart ein Rückseitenbeleuchtungssystem mit mehreren LED-Substraten, die jeweils mehrere LEDs aufweisen. In der Vorrichtung sind mehrere rechteckige Platinen nebeneinander angeordnet.

US 2008/0231776 A1 offenbart eine Rückseitenbeleuchtung und eine LCD-Anzeige mit einer solchen Beleuchtung. Die Einrichtung umfasst ein erstes Substrat und ein zweites Substrat, die nebeneinander angeordnet sind und elektrisch verbunden sind. Die Substrate sind mit LEDs bestückt.

Aufgabe der vorliegenden Erfindung ist es, LED-Leiterplatten zur Ausbildung von quadratischen Leuchten und Langfeldleuchten bereitzustellen, welche die Verwendung von jeweils gleichen LED-Leiterplatten ermöglichen und weniger Störstellen in dem LED-Muster der aneinandergefügten Leiterplatten bilden.

Die Aufgabe wird gelöst durch eine Anordnung nach Anspruch 1.

Die besondere Ausgestaltung der Leiterplatten mit einer unterschiedlichen Anzahl von Spalten und Reihen der LED-Positionen ermöglicht die quadratische Anordnung von vier Platten in zyklischer Abfolge, wobei eine Störstelle an den aneinandergrenzenden Seiten nur in der Mitte der Platte gebildet wird. Diese einzelne Störstelle, welche eine quadratische Öffnung mit einer Seitenlänge darstellt, welche der Differenz zwischen der längeren und kürzeren Seite der Platte entspricht, ist kaum sichtbar oder kann ggf. durch eine geringe Anzahl LEDs oder eine einzelne LED ausgefüllt werden. Ferner eignen sich die erfindungsgemäßen Leiterplatten ebenso zur Ausbildung von Langfeldleuchten, d.h. für eine nicht-quadratische Anordnung von mehreren Leiterplatten entlang einer Vorzugsrichtung. Die Leiterplatten gemäß der vorliegenden Erfindung sind daher für alle vorgegebenen Einsatzzwecke in vorteilhafter Weise anwendbar.

Gemäß einer bevorzugten Ausführungsform ist die Anzahl der Spalten gerade und die Anzahl der Reihen ungerade oder die Anzahl der Spalten ist ungerade und die Anzahl der Reihen gerade. Diese Ausführungsform eignet sich insbesondere für Leiterplatten mit genau zwei verschiedenen Gruppen von LEDs, die beispielsweise innerhalb der Reihen oder Spalten abwechselnd angeordnet sind oder auf benachbarte Reihen oder Spalten, die gegeneinander versetzt sind, verteilt sind.

Gemäß einer bevorzugten Ausführungsform unterscheidet sich die Anzahl der Spalten und Reihen um höchstens 5, bevorzugt um höchstens 3 und insbesondere um genau 1. Bei dieser Ausführungsform bildet sich bei einer Anordnung von vier gleichen Leiterplatten in der Mitte eine Öffnung von höchstens 5 x 5, 3 x 3 oder einer einzelnen LED-Position. Diese Störstelle kann durch eine entsprechende kleinere zusätzliche Leiterplatte mit einer, vier bzw. neun LED-Positionen ausgefüllt werden.

Gemäß einer bevorzugten Ausführungsform sind die Spalten benachbarter Reihen versetzt zueinander angeordnet. Insbesondere können für zwei Gruppen die Spalten mit einer Periodizität von zwei entlang der Reihen versetzt angeordnet werden. Für drei oder mehr Gruppen kann die Periodizität der Versetzung auch drei oder mehr betragen. Die Spalten auf gleicher Höhe in den Reihen tragen jeweils die gleiche LED-Gruppe.

Gemäß einer alternativen Ausführungsform können die Spalten benachbarter Reihen auch nicht versetzt angeordnet sein. Bei dieser Ausführungsform sind die wenigstens zwei verschiedenen Gruppen von LEDs innerhalb der Spalten bzw. Reihen mit einer Periodizität von zwei oder mehr angeordnet sein. Es ergibt sich demnach ein regelmäßiges Gitter mit einem Translationsvektor in x-Richtung und y-Richtung von jeweils zwei Gitterpositionen. Entsprechend kann das Muster auch mit drei oder mehr Gruppen mit einem Translationsvektor von drei oder mehr Gitterpositionen entlang der x- und y-Richtung ausgebildet werden.

Gemäß einer bevorzugten Ausführungsform sind die kürzere und längere Seite der recheckigen Leiterplatte gerade Linien, so dass die kürzere und die längere Seite lückenlos aneinander angefügt werden können. Gemäß einer alternativen Ausführungsform kann die kürzere und längere Seite auch eine regelmäßig meandernde Linie definieren, wobei die Form der Linien so gewählt ist, dass ebenfalls die kürzere und längere Seite aneinandergefügt werden können mit einer Versetzung, welcher der Differenz zwischen der Anzahl der Reihen und Spalten entspricht. In beiden Ausführungsformen ist ein lückenloses aneinanderfügen der Leiterplatten zum Bilden einer quadratischen Anordnung von Leiterplatten oder zur Ausbildung einer länglichen Anordnung von Leiterplatten möglich. Der Begriff "lückenlos" ist so zu verstehen, dass eine einzelne Öffnung in der Mitte oder Lücken im Bereich der Seitenränder, ohne das LED-Muster zu stören, dennoch erlaubt sind.

Gemäß einer bevorzugten Ausführungsform sind die LEDs in den äußeren Reihen und/oder Spalten entlang einer Seite von der betreffenden Seite in einem Abstand angeordnet, der dem halben Abstand zwischen den Reihen bzw. Spalten innerhalb der Leiterplatte entspricht. Durch diese Abstandswahl ist gewährleistet, dass der Abstand zwischen den äußersten LED-Reihen bzw. Spalten aneinandergefügter Leiterplatten dem gleichen Abstand entspricht, wie der Abstand der Reihen bzw. Spalten innerhalb der Platte.

Gemäß einer bevorzugten Ausführungsform weisen die Leiterplatten Befestigungspunkte auf. Die Befestigungspunkte können insbesondere durch Durchgangslöcher gebildet sein, mittels derer die Leiterplatten z.B. an einem Gehäuse angeschraubt werden. Alternativ können auch Steckkontakte oder andere form- oder kraftschlüssige Verbindungspunkte zum Anbringen der Leiterplatten in einem Leuchtengehäuse die Befestigungspunkte definieren.

Gemäß einer bevorzugten Ausführungsform sind die Befestigungspunkte auf Kreisbahnen und/oder Diagonalen um bzw. durch einen Mittelpunkt einer aneinandergefügten Anordnung von vier der genannten Leiterplatten vorgesehen, wobei die vier Leiterplatten zyklisch zueinander gedreht sind und in der Mitte eine quadratische Lücke definieren, deren Seitenlänge der Differenz zwischen der längeren und der kürzeren Seite entspricht. Diese Anordnung von Befestigungspunkten hat den Vorteil, dass von der Mitte eine Anordnung von vier Leiterplatten ausgehend die Leiterplatten in gleichmäßigen Abständen im Gehäuse befestigt werden können, um ein Durchbiegen der Leiterplatten durch ihr eigenes Gewicht zu verhindern. Die Anordnung dieser Befestigungspunkte eignet sich nicht nur für die Anordnung von vier Leiterplatten in einem Quadrat, sondern ebenso zur Ausbildung einer Langfeldleuchte mit einer Anordnung der Leiterplatten in einer Längsrichtung. Insbesondere die Diagonalen, wie vorhergehend definiert, gewährleisten eine gleichmäßige Verteilung der Befestigungspunkte über der Anordnung von mehreren Leiterplatten in einer Längsrichtung.

Gemäß einer bevorzugten Ausführungsform können die Befestigungspunkte innerhalb der Fläche der Leiterbahnen und/oder an den Seiten der Leiterbahnen angeordnet sein, wobei in letzterem Fall insbesondere ein Befestigungspunkt durch zwei aneinandergrenzende Leiterplatten gebildet wird. Beispielsweise kann an einer Seite der Leiterplatte ein halbrundes Loch vorgesehen sein, welches mit der angrenzenden Seite einer benachbarten Leiterplatte eine vollständige Kreisöffnung bildet.

Gemäß einer Ausführungsform können Leiterbahnen zur elektrischen Versorgung der LED-Position diagonal zu den Spalten und Reihen auf der Leiterplatte vorgesehen sein. Durch jeweils zwei benachbarte Diagonalen lassen sich in der Ausführungsform mit zwei LED-Gruppen jeweils die LED-Positionen einer Gruppe miteinander verbinden. Die Leiterbahnen können die LEDs einer Reihen- oder in einer Parallelschaltung verbinden. Es ist auch möglich, dass jeweils eine vorgegebene Anzahl von LEDs hintereinander in Reihe und die darauffolgende Anzahl von LEDs parallel miteinander elektrisch verbunden sind.

Gemäß einer alternativen Ausführungsform können Leiterbahnen zur Versorgung der LED-Positionen auch parallel zu den Spalten und/oder Reihen vorgesehen sein. Diese Ausführungsform eignet sich insbesondere für Leiterplatten mit versetzten Spalten oder zur Verbindung von LED-Positionen mit Leiterbahnen zwischen den Spalten oder Reihen.

Die vorliegende Erfindung betrifft eine Anordnung von vier gleichen Leiterplatten jeweils nach einer der vorhergehend genannten Ausführungsformen zur Bildung einer quadratischen LED-Leuchte, wobei die vier Leiterplatten jeweils zyklisch zueinander gedreht sind und in der Mitte eine quadratische Lücke aufweisen, deren Seitenlänge der Differenz zwischen der längeren und der kürzeren Seite entspricht. Diese Anordnung hat den Vorteil, dass sich das Muster der LED-Position über die Anordnung aller Leiterplatten regelmäßig fortsetzt mit Ausnahme einer einzelnen Störstelle in der Mitte, die beispielsweise durch eine einzelne LED oder eine kleine Anzahl von LEDs auf einer separaten Platinen ausgeführt werden kann.

Gemäß einer alternativen Ausführungsform kann die Erfindung auch eine Anordnung von zwei, drei, vier oder mehr gleichen Leiterplatten jeweils nach einer der vorhergehend genannten Ausführungsformen zur Bildung einer LED-Langfeldleuchte vorgesehen sein, wobei die zwei, drei, vier oder mehr Leiterplatten zueinander translatorisch versetzt sind und jeweils entlang ihrer kürzeren oder längeren Seite senkrecht zu der Richtung der Längserstreckung der Langfeldleuchte aneinander angefügt sind.

Gemäß weiteren Ausführungsformen ist es auch möglich, beispielsweise ein Muster von jeweils vier Leiterplatten gemäß der zyklischen Anordnung mit einer oder mehreren weiteren Anordnung von zwei oder vier Leiterplatten entlang einer Richtung zu kombinieren, um eine Langfeldleuchte mit einer größeren Breite auszubilden.

Insbesondere können die Leiterplatten der vorliegenden Erfindung derart ausgebildet sein, um Deckeneinbauleuchten für Deckenausschnitte mit einem Standardmaß von 600 x 600 mm oder 625 x 625 mm zu bilden. In diesem Fall sind die Leiterplatten bevorzugt entlang ihrer längeren Seite 250 mm bis 310 mm lang und entlang ihrer kürzeren Seite 234,4 mm bis 290,6 mm lang. Bei einer besonders bevorzugten Ausführungsform sind die Abmessungen der Leiterplatten entlang der längeren Seite 280 mm und entlang der kürzeren Seite 262,5 mm, wobei Abweichungen bis ±5% vorgesehen sind.

Bevorzugte Ausführungsformen der vorliegenden Erfindung werden anhand der beigefügten Figuren nachfolgend beschrieben. In den Figuren ist Folgendes dargestellt:
- Figuren 1a und 1b: zeigen Anordnungen von herkömmlichen quadratischen Leiterplatten;
- Figur 2: zeigt eine Anordnung von herkömmlichen quadratischen Leiterplatten;
- Figur 3: zeigt eine Anordnung von herkömmlichen quadratischen Leiterplatten;

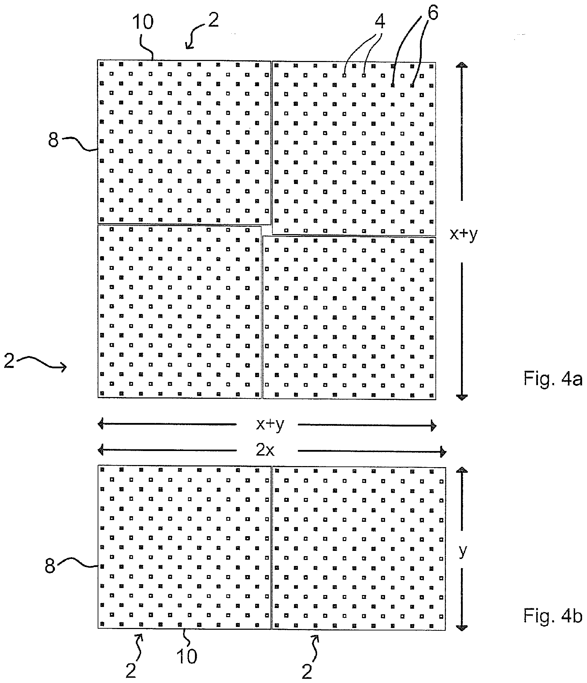

- Figuren 4a und 4b: zeigen die Anordnungen von vier bzw. zwei Leiterplatten gemäß der vorliegenden Erfindung;

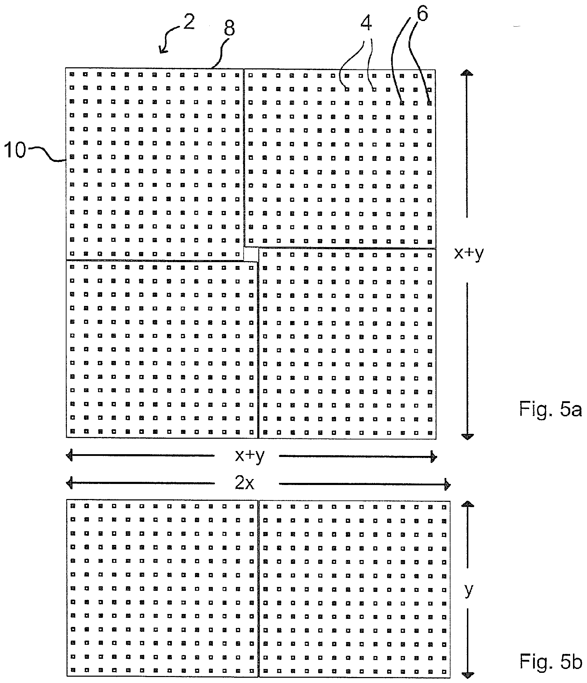

- Figuren 5a und 5b: zeigen eine Anordnung von vier bzw. zwei Leiterplatten gemäß einer alternativen Ausführungsform der vorliegenden Erfindung;

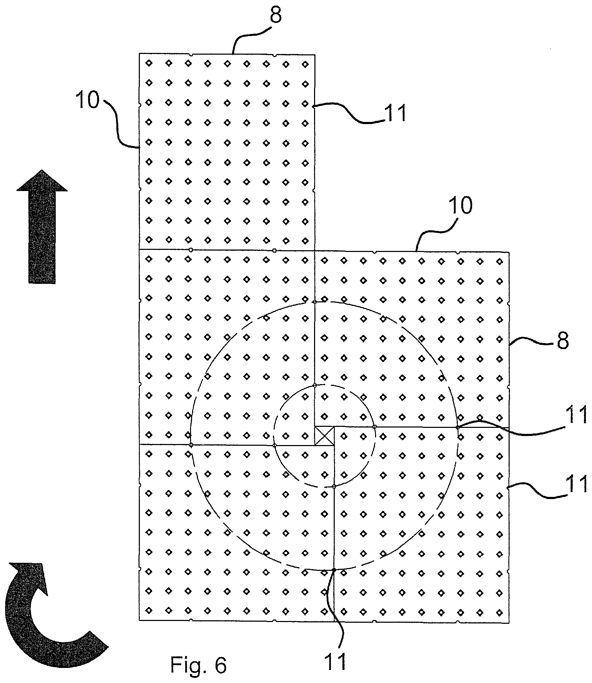

- Figur 6: zeigt eine Anordnung von Leiterplatten gemäß der vorliegenden Erfindung mit Befestigungspunkten;

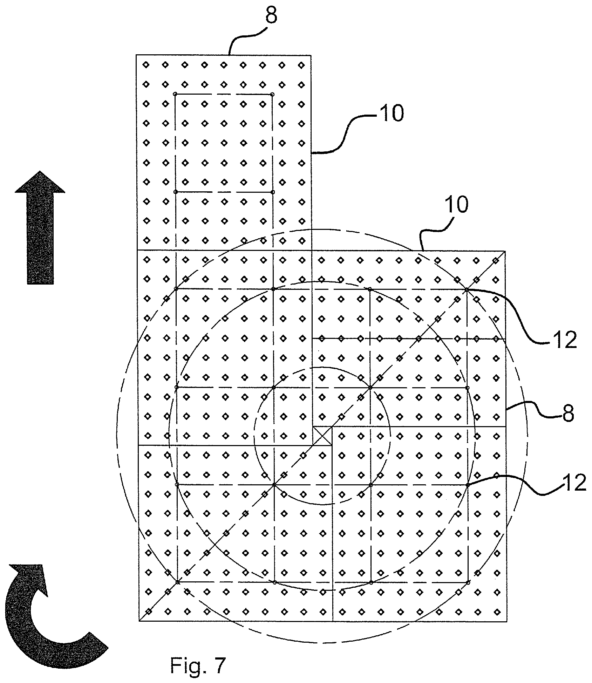

- Figur 7: zeigt eine Anordnung von Leiterplatten gemäß der vorliegenden Erfindung mit einer alternativen Anordnung von Befestigungspunkten;

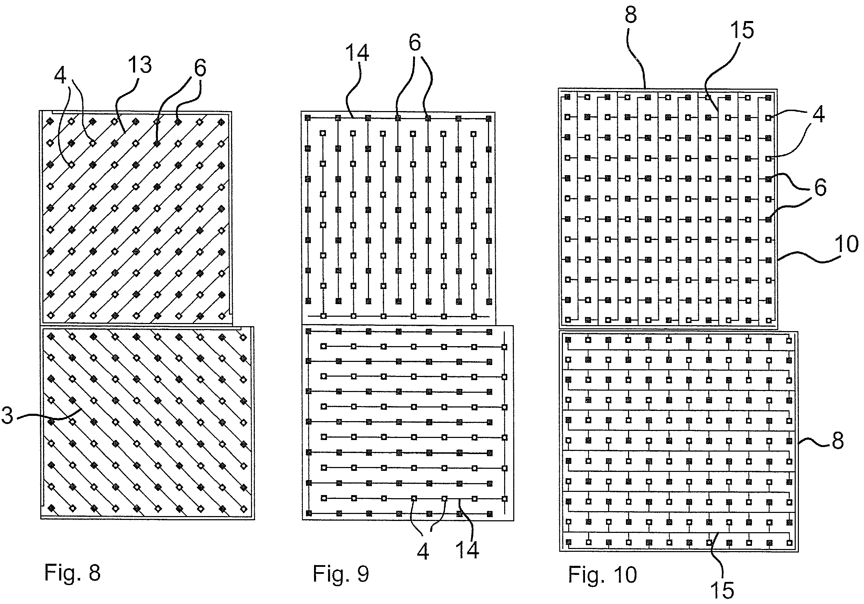

- Figur 8: zeigt eine Anordnung von Leiterplatten mit diagonalen Leiterbahnen gemäß der vorliegenden Erfindung;
- Figur 9: zeigt eine Anordnung von Leiterplatten mit parallelen Leiterbahnen gemäß der vorliegenden Erfindung; und
- Figur 10: zeigt eine Anordnung von Leiterplatten mit parallelen Leiterbahnen gemäß einer alternativen Ausführungsform der vorliegenden Erfindung.

Die Figuren 2 und 3 stellen Anordnungen von herkömmlichen quadratischen Leiterplatten dar, die gemäß der Figur 1a zyklisch um den Mittelpunkt gedreht sind. Es ist zu erkennen, dass entlang der Verbindungslinien zwischen den Leiterplatten (siehe Pfeile in den Figuren 2 und 3) die regelmäßige Anordnung von LEDs gestört ist, wenn ein Muster von zwei LED-Gruppen, die mit hellen und dunklen Quadraten dargestellt sind, auf den quadratischen Platinen vorgesehen ist.

Die Figur 4a zeigt die Anordnung von vier Leiterplatten 2 gemäß einer ersten Ausführungsform der Erfindung. Die Leiterplatte 2 weist eine regelmäßige Anordnung von LED-Positionen auf, welche elektrisch kontaktiert sind, um an diesen Positionen LEDs anzuschließen. Es gibt zwei Gruppen von LED-Positionen 4 und 6, die mit unterschiedlichen Arten von LEDs (z.B. mit unterschiedlichen Farben) bestückt sind oder die so kontaktiert sind, dass sie voneinander unabhängig elektrisch geschaltet werden können. Die LED-Positionen sind in zwei unterschiedlichen Reihen oder Spalten angeordnet, wobei die Spalten und Reihen längs den Seitenrändern der Platine 2 verlaufen. Eine Reihe bzw. eine Spalte umfassen jeweils LED-Positionen 4 bzw. 6 einer Gruppe (durch helle und dunkle Quadrate dargestellt).

Die Leiterplatte 2 weist die Form eines Rechtecks auf mit einer längeren Seite 8 der Länge x und an der kürzeren Seite 10 der Länge y. Entlang der kürzeren Seite 8 sind in dem gezeigten Beispiel 17 LED-Reihen angeordnet, während entlang der längeren Seite 10 in dem gezeigten Beispiel 19 LED-Spalten angeordnet sind. Es ist zu verstehen, dass diese Zahl der Reihen und Spalten nur ein Beispiel bilden. Wichtig ist jedoch, dass sich die Anzahl der Spalten und Reihen entlang der kürzeren und der längeren Seite um wenigstens 1 unterscheiden, im Unterschied zu den in den Figuren 2 und 3 gezeigten quadratischen Platinen, welche nur gleich lange Seiten mit jeweils der gleichen Anzahl von Reihen und Spalten aufweisen.

In der Figur 4a sind vier Leiterplatten 2 in einem Quadrat angeordnet, wobei die Leiterplatten jeweils mit einer kürzeren und einer längeren Seite 8 und 10 aneinander angrenzen. Dadurch ergibt sich ein regelmäßiges Muster der zwei Gruppen von LED-Positionen 4 und 6, welche sich auch über die Platten hinweg erstreckt, im Unterschied zu dem in Figur 2 dargestellten Beispiel, bei welchem es eine Abweichung entlang der Verbindungskanten gibt. Eine einzige Störstelle in dem Muster in der Ausführungsform nach Figur 4a ergibt sich im Mittelpunkt. Dort fehlt eine einzelne LED der ersten Gruppe 4. Diese Fehlstelle ist bei einer vollständigen Leuchte jedoch kaum sichtbar oder kann durch eine einzelne LED zur Vervollständigung des Musters ergänzt werden.

Die Leiterplatten 2 der ersten Ausführungsform eignen sich, wie in Figur 4b dargestellt, auch zur Anordnung nebeneinander, um eine Anordnung für eine Langfeldleuchte mit einer Länge 2x zu bilden. Die gleichen Leiterplatten wie in der Figur 4a können auch entlang ihrer kürzeren Seite 8 aneinandergefügt werden, um eine Anordnung mit der Länge 2y zu bilden.

Die Figuren 5a und b zeigen Leiterplatten 2 einer zweiten Ausführungsform. Bei diesen Leiterplatten sind die LED-Positionen 4 und 6 von zwei verschiedenen LED-Gruppen jeweils in einer Reihe bzw. Spalte abwechselnd angeordnet. Wie bei der ersten Ausführungsform weisen die Leiterplatten 2 eine kürzere Seite 8 und eine längere Seite 10 auf, so dass sie mit jeweils einer kürzeren Seite 8 und einer längeren Seite 10 aneinander angefügt werden können, um ein Quadrat von vier Leiterplatten zu bilden, über welche sich das Muster der LEDs regelmäßig fortsetzt. Wie bei der ersten Ausführungsform bleibt bei der quadratischen Anordnung von vier Leiterplatten 2 in der Mitte eine einzelne Leerstelle übrig, die ggf. durch eine einzelne LED der ersten Gruppe 4 ergänzt werden kann.

Auch bei der zweiten Ausführungsform ist es möglich, zwei oder mehr Leiterplatten entlang gleicher Seiten (entweder der längeren Seite 10 oder der kürzeren Seite 8) hintereinander anzuordnen, um ein regelmäßiges Muster von LEDs der zwei Gruppen für eine Langfeldleuchte zu bilden, wie in Figur 5b dargestellt.

Für beide Ausführungsformen ist zu beachten, dass der Abstand der LEDs zum äußeren Rand der Platte 2, d.h. der kürzeren Seite 8 und der längeren Seite 10, jeweils dem halben Abstand zwischen den LED-Spalten und -Reihen entspricht. Dadurch ist gewährleistet, dass sich auch zwischen zwei aneinander angefügten Platten der gleiche Abstand zwischen den LEDs ergibt, wie innerhalb der Platte 2, um das Muster der LEDs regelmäßig über die aneinandergefügten Platten 2 fortzusetzen.

Die Figur 6 zeigt ein Beispiel von Leiterplatten 2 gemäß der vorliegenden Erfindung mit Befestigungspunkten 11. Die Befestigungspunkte 11 sind in diesem Ausführungsbeispiel jeweils an den Seiten der Leiterplatten 2 gebildet, so dass zwei aneinandergrenzende Leiterplatten 2 jeweils einen Befestigungspunkt 11 bilden. An diesen Befestigungspunkten 11 können beispielsweise durch Schrauben die Leiterplatten 2 in einem Leuchtengehäuse gehalten werden.

Die Befestigungspunkte 11 sind an den Seiten 8 und 10 derart angeordnet, dass die Befestigungspunkte bei einer quadratischen Anordnung von vier Leiterplatten 2 jeweils auf konzentrischen Kreisen um den Mittelpunkt der Anordnung zu liegen kommen. Dadurch ist eine gleichmäßige Befestigung der Leiterplatten 2 in einem Leuchtengehäuse möglich.

Ferner ist in Figur 6 dargestellt, dass bei einer Anordnung von vier Leiterplatten nach oben weitere Leiterplatten 2 angefügt werden können, um eine sich längs erstreckende Leuchte mit einem sich regelmäßig fortsetzendem Muster der LEDs zu bilden.

In der Figur 7 ist eine alternative Ausführungsform der Leiterplatten 2 mit Befestigungspunkten 12 dargestellt. Bei diesen Leiterplatten befinden sich die Befestigungspunkte 12 innerhalb der Flächen der Leiterplatten. Diese Befestigungspunkte 12 sind so angeordnet, dass sie sich auf Diagonalen durch den Mittelpunkt der quadratischen Anordnung von vier Leiterplatten befinden. Ferner befinden sich die Befestigungspunkte 12 außerdem auf den Schnittpunkten zu konzentrischen Kreisen um den Mittelpunkt der Anordnung von vier Leiterplatten. Dadurch ergibt sich über die Anordnung hinweg ein regelmäßiges Muster von Befestigungspunkten in einem quadratischen Gitter. Die Leiterplatten lassen sich auf diese Weise gleichmäßig in einem Leuchtengehäuse befestigen. Dies gilt insbesondere auch dann, wenn die Anordnung der vier Leiterplatten 2 um weitere Leiterplatten an einer Seite ergänzt wird, wie in Figur 7 oben gezeigt.

Die Figuren 8 bis 10 stellen verschiedene Ausführungsformen für die Anordnung von Leiterbahnen auf den Leiterplatten 2 dar. Gemäß Figur 8 sind Leiterbahnen 14 diagonal zu den Reihen und Spalten angeordnet. Beispielsweise können die LED-Positionen der ersten Gruppe 4 und der zweiten Gruppe 6 jeweils in einer Reihenschaltung miteinander verbunden werden.

In Figur 9 sind die Leiterbahnen 4 parallel zu den Reihen und im Randbereich auch parallel zu den Spalten angeordnet. Beispielsweise können die LED-Positionen der ersten Gruppe durch eine Reihen- und Parallelschaltung und die LED-Positionen 6 der zweiten Gruppe durch eine davon getrennte Reihen- und Parallelschaltung verbunden werden.

Figur 10 zeigt eine alternative Ausführungsform, bei welcher Leiterbahnen 15 in einer Richtung parallel zu der längeren Seite 10 der Leiterplatten angeordnet sind. Die Leiterbahnen 15 sind jeweils zwischen zwei Spalten angeordnet und abwechselnd mit den LEDs der angrenzenden Spalten verbunden.

Die vorhergehend mit Bezug auf die Figuren beschriebenen Ausführungsformen der Leiterplatten 2 weisen jeweils eine Differenz der Anzahl von Spalten und Reihen von genau 1 auf. Es ist zu verstehen, dass die Erfindung jedoch auch einen größeren Unterschied von Reihen und Spalten, insbesondere z.B. drei oder fünf, aufweisen kann. In diesem Fall ergibt sich in der Mitte eine Leerstelle, die vier oder neun LED-Positionen umfasst.

Die LED-Gruppen sind vorzugsweise alle mit LEDs besetzt, um z.B. zwei verschiedene Helligkeitsstärken einer Leuchte schalten zu können oder um zwei Farben miteinander zu mischen. Gemäß vereinfachten Ausführungsformen ist es jedoch auch möglich, dass eine Gruppe von LED-Positionen vollständig unbesetzt bleibt. Trotzdem wird die Leiterplatte 2 mit den LED-Positionen der zweiten Gruppen ausgebildet, um die gleichen Leiterplatten 2 auch für andere Leuchten mit der doppelten Anzahl von LEDs einsetzen zu können.

Die im Zusammenhang mit den Figuren beschriebenen Ausführungsformen umfassen zwei Gruppen von LEDs 4 und 6. Es ist zu verstehen, dass auch mehr als zwei Gruppen, insbesondere drei Gruppen, angewandt werden können, um beispielsweise die Farben Rot, Grün und Blau abzudecken. Bei diesen Ausführungsformen ist eine Differenz der Anzahl der Reihen und Spalten von zwei, vier oder einer anderen geraden Zahl bevorzugt.

Ferner ist zu verstehen, dass die LED-Positionen der unterschiedlichen Gruppen auch unterschiedliche Abstände aufweisen können.

### Bezugszeichenliste:

- 2: Leiterplatte
- 4: LED-Position der ersten Gruppe
- 6: LED-Position der zweiten Gruppe
- 8: kürzere Seite
- 10: längere Seite
- 11: Befestigungspunkt
- 12: Befestigungspunkt
- 13: Leiterbahn
- 14: Leiterbahn
- 15: Leiterbahn

## Patentansprüche

1. Anordnung aus wenigstens vier Leiterplatten (2), mit jeweils einer regelmäßigen Anordnung von Positionen (4, 6) zur Bestückung mit LEDs, wobei jede der Leiterplatten (2) eine rechteckige Grundform aufweist,
wobei die LED-Positionen (4, 6) in Spalten und Reihen parallel zu zwei rechtwinkligen Seiten (8, 10) des Rechtecks angeordnet sind und die LED-Positionen in wenigstens zwei verschiedenen Gruppen ansteuerbar und/oder mit zwei Gruppen verschiedener LEDs bestückt sind, wobei die nächsten Nachbarn der LED-Positionen (4, 6) innerhalb der gleichen Reihe und/oder in den benachbarten Reihen zu unterschiedlichen Gruppen gehören,
wobei jede der Leiterplatten (2) eine kürzere (8) und eine längere (10) Seite aufweist und die Anzahl der Spalten und Reihen entlang der beiden Seiten unterschiedlich ist, **dadurch gekennzeichnet, dass** zur Bildung einer quadratischen LED-Leuchte die vier Leiterplatten (2) jeweils zyklisch zueinander gedreht sind und in der Mitte eine quadratische Lücke aufweisen, deren Seitenlänge der Differenz zwischen der längeren (10) und der kürzeren (8) Seite entspricht.

2. Anordnung nach Anspruch 1, wobei die Anzahl von Spalten gerade und die Anzahl von Reihen ungerade ist oder umgekehrt.

3. Anordnung nach einem der vorhergehenden Ansprüche, wobei sich die Anzahl der Spalten und Reihen um höchstens 5, bevorzugt um höchstens 3 und insbesondere bevorzugt um genau 1 unterscheidet.

4. Anordnung nach einem der vorhergehenden Ansprüche, wobei es genau zwei Gruppen der genannten Gruppen gibt.

5. Anordnung nach einem der vorhergehenden Ansprüche, wobei die LED-Positionen in den Spalten benachbarter Reihen versetzt zueinander angeordnet sind.

6. Anordnung nach einem der Ansprüche 1 bis 4, wobei die LED-Positionen in den Spalten benachbarter Reihen nicht versetzt sind.

7. Anordnung nach einem der vorhergehenden Ansprüche, wobei die kürzere und längere Seite (8, 10) jede der rechteckigen Leiterplatte gerade Linien oder eine regelmäßige meandernde Linie definieren, so dass die kürzere und die längere Seite von zwei gleichen Leiterplatten um die Differenz zwischen der Anzahl der Reihen und Spalten versetzt lückenlos aneinanderfügbar sind.

8. Anordnung nach einem der vorhergehenden Ansprüche, wobei der Abstand der LEDs in der äußeren Reihe und/oder Spalte entlang einer Seite (8, 10) zu der Seite etwa dem halben Abstand zwischen den Reihen und/oder Spalten innerhalb jeder der Leiterplatten (2) beträgt.

9. Anordnung nach einem der vorhergehenden Ansprüche, wobei die Leiterplatten Befestigungspunkte (11, 12) aufweist, insbesondere Durchgangslöcher.

10. Anordnung nach Anspruch 9, wobei die Befestigungspunkte (11, 12) auf Kreisbahnen und/oder Diagonalen um bzw. durch einen Mittelpunkt der aneinandergefügten Anordnung von vier Leiterplatten (2) angeordnet sind, wobei die vier Leiterplatten (2) zyklisch zueinander gedreht sind und in der Mitte eine quadratische Lücke definieren, deren Seitenlänge der Differenz zwischen der längeren (10) und der kürzeren (8) Seite entspricht.

11. Anordnung nach Anspruch 9 oder 10, wobei die Befestigungspunkte (11, 12) innerhalb der Flächen der Leiterplatten (2) und/oder an den Seiten (8, 10) der Leiterplatten angeordnet sind, wobei in letzterem Fall insbesondere ein Befestigungspunkt (11) durch zwei aneinandergrenzende Leiterplatten (2) gebildet wird.

12. Anordnung nach einem der vorhergehenden Ansprüche, wobei Leiterbahnen (13) zur elektrischen Versorgung der LED-Positionen diagonal zu den Spalten und Reihen auf der Leiterplatte vorgesehen sind.

13. Anordnung nach einem der Ansprüche 1 bis 11, wobei Leiterbahnen (14, 15) zur Versorgung der LED-Positionen parallel zu den Spalten und/oder Reihen vorgesehen sind.

## Claims

1. Arrangement of at least four circuit boards (2), with in each case a regular arrangement of positions (4, 6) for fitting with LED's, wherein each of the circuit boards (2) exhibits a rectangular basic form,
wherein the LED positions (4, 6) are arranged in slots and rows parallel to two rectangular sides (8, 10) of the rectangle, and the LED positions can be actuated in at least two different groups and/or with two groups of different LED's, wherein the nearest neighbours of the LED positions (4, 6) inside the same row and/or in the adjacent rows belong to different groups,
wherein each of the circuit boards (2) exhibits a shorter (8) and a longer (10) side, and the number of slots and rows along the two sides is different, **characterized in that**, in order to form a square LED light, the four circuit boards (2) are in each case rotated cyclically in relation to one another, and in the middle exhibit a square gap, the side length of which corresponds to the difference between the longer (10) and the shorter (8) side.

2. Arrangement according to claim 1, wherein the number of slots is even and the number of rows is odd, or vice-versa.

3. Arrangement according to any one of the preceding claims, wherein the number of slots and rows differ by a maximum of 5, preferably by a maximum of 3, and for particular preference by exactly 1.

4. Arrangement according to any one of the preceding claims, wherein there are precisely two groups of the said groups.

5. Arrangement according to any one of the preceding claims, wherein the LED positions in the slots of adjacent rows are arranged offset to one another.

6. Arrangement according to any one of claims 1 to 4, wherein the LED positions in the slots of adjacent rows are not offset.

7. Arrangement according to any one of the preceding claims, wherein the shorter and longer side (8, 10) of each of the rectangular circuit boards define straight lines or a regularly meandering line, such that the shorter and the longer side of two same circuit boards can be matched together, without a gap, offset by the difference between the number of the rows and slots.

8. Arrangement according to any one of the preceding claims, wherein the distance interval between the LED's in the outer row and/or slot along one side (8, 10) to the side itself amounts approximately to half the distance interval between the rows and/or slots inside each of the circuit boards (2).

9. Arrangement according to any one of the preceding claims, wherein the circuit boards comprise fastening points (11, 12), in particular passage apertures.

10. Arrangement according to claim 9, wherein the fastening points (11, 12) are arranged on circular trajectories and/or diagonals respectively around or though a middle point of the matched arrangement of four circuit boards (2), wherein the four circuit boards (2) are rotated cyclically to one another and in the middle define a square gap, the side length of which corresponds to the difference between the longer (10) and the shorter side (8).

11. Arrangement according to claim 9 or 10, wherein the fastening points (11, 12) are arranged inside the surfaces of the circuit boards (2) and/or the sides (8, 10) of the circuit boards, wherein, in the latter case, in particular one fastening point (11) is formed by two adjacent circuit boards (2).

12. Arrangement according to any one of the preceding claims, wherein circuit board conductors (13) for the electrical supply of the LED positions are provided diagonally to the slots and rows on the circuit board.

13. Arrangement according to any one of claims 1 to 11, wherein circuit board connectors (14, 15) for the supply of the LED positions are provided parallel to the slots and/or rows.

## Revendications

1. Dispositif constitué d'au moins quatre circuits imprimés (2), avec chacun une disposition régulière d'emplacements (4, 6) pour un équipement avec des LED, chacun des circuits imprimés (2) présentant une forme de base rectangulaire,
les emplacements des LED (4, 6) étant disposés en colonnes et en lignes parallèlement à deux côtés perpendiculaires (8, 10) du rectangle et les emplacements des LED pouvant être commandés en au moins deux groupes et/ou étant équipés de deux groupes de différentes LED, les voisins les plus proches des emplacements des LED (4, 6) à l'intérieur de la même ligne et/ou dans les lignes adjacentes appartenant à des groupes différents,
chacun des circuits imprimés (2) comprenant un côté court (8) et un côté long (10) et le nombre de colonnes et de lignes étant différent le long des deux côtés, **caractérisé en ce que**, pour la formation d'un luminaire à LED carré, les quatre circuits imprimés (2), sont tournés de manière cyclique les uns par rapport aux autres et présentent, au centre, une lacune carrée dont la longueur de côté correspond à la différence entre le côté long (10) et le côté court (8).

2. Dispositif selon la revendication 1, le nombre de colonnes étant pair et le nombre de lignes étant impair ou inversement.

3. Dispositif selon l'une des revendications précédentes, les nombres de colonnes et de lignes étant différents de 5 maximum, de préférence de 3 maximum et plus particulièrement de préférence de 1 exactement.

4. Dispositif selon l'une des revendications précédentes, moyennant quoi il y a exactement deux groupes des groupes mentionnés.

5. Dispositif selon l'une des revendications précédentes, les emplacements des LED étant disposés de manière décalée entre eux dans les colonnes de lignes adjacentes.

6. Dispositif selon l'une des revendications 1 à 4, les emplacements des LED n'étant pas décalés dans les colonnes de lignes adjacentes.

7. Dispositif selon l'une des revendications précédentes, le côté court et le côté long (8, 10) de chacun des circuits imprimés rectangulaires définissent des lignes droites ou une ligne sinusoïdale régulière, de façon à ce que le côté court et le côté long de deux circuits imprimés identiques puissent être assemblés sans interstice de manière décalée de la différence entre le nombre de lignes et de colonnes.

8. Dispositif selon l'une des revendications précédentes, la distance des LED dans la ligne et/ou la colonne extérieure le long d'un côté (8, 10), par rapport au côté, est égale à environ la moitié de la distance entre les lignes et/ou les colonnes à l'intérieur de chacun des circuits imprimés (2).

9. Dispositif selon l'une des revendications précédentes, le circuit imprimé comprenant des points de fixation (11, 12), plus particulièrement des trous traversants.

10. Dispositif selon la revendication 9, les points de fixation (11, 12) étant disposés sur des pistes circulaires et/ou des diagonales autour ou à travers un point central de la disposition assemblée de quatre circuits imprimés (2), les quatre circuits imprimés (2) étant tournés de manière cyclique les uns par rapport aux autres et définissent, au centre, un trou carré dont la longueur de côté correspond à la différence entre le côté long (10) et le côté court (8).

11. Dispositif selon la revendication 9 ou 10, les points de fixation (11, 12) étant disposés à l'intérieur des surfaces des circuits imprimés (2) et/ou sur les côtés (8, 10) des circuits imprimés, moyennant quoi, dans ce dernier cas, plus particulièrement, un point de fixation (11) est constitué de deux circuits imprimés (2) adjacents.

12. Dispositif selon l'une des revendications précédentes, des pistes conductrices (13) étant prévues pour l'alimentation électrique des emplacements des LED, en diagonale par rapport aux colonnes et lignes sur le circuit imprimé.

13. Dispositif selon l'une des revendications 1 à 11, des pistes conductrices (14, 15) étant prévues pour l'alimentation des emplacements des LED parallèlement aux colonnes et/ou aux lignes.
